# FASCICULE DE BREVET EUROPEEN

(11) **EP 0 561 669 B1**
(45) Date de publication et mention de la délivrance du brevet: **11.12.1996**
(21) Numéro de dépôt: 93400599.2
(22) Date de dépôt: 09.03.1993
(51) Int. Cl.: H03K 17/96, H03K 17/94, G06K 11/16

(54) **Dispositif de désignation tactile**
Vorrichtung zur Eingabe mittels Berührung
Touch input device

(30) Priorité: 17.03.1992 FR 9203165
(43) Date de publication de la demande: 22.09.1993
(73) Titulaire: SEXTANT Avionique, F-92368 Meudon la Forêt Cédex (FR)
(72) Inventeur: Fagard, Pierre, F-78180 Montigny le Bretonneux (FR); Nigen, Claude, F-78150 Le Chesnay (FR); Coppin, Jean-Marc, F-94190 Villeneuve Saint Georges (FR); Caugant, Xavier, F-78000 Versailles (FR)
(74) Mandataire: Bloch, Gérard

(56) Documents cités:
- EP-A- 0 388 346
- EP-A- 0 422 361
- FR-A- 2 374 811
- PATENT ABSTRACTS OF JAPAN vol. 7, no. 164 (P-211)(1309) 19 Juillet 1983 & JP-A-58 72 277

## Description

La présente invention concerne un dispositif de désignation tactile à détection capacitive continue, comportant une plaque de verre recouverte d'un dépôt métallique sur sensiblement toute sa surface et supportée par des lames déformables, des moyens d'alimentation de la surface métallisée, et des jauges de contraintes montées sur lesdites lames pour mesurer leur déformation.

Dans ces dispositifs connus, le dépôt métallique conducteur est recouvert d'un isolant sur sa surface utile, ce qui peut être réalisé par un traitement en couches minces avec dépôt d'un anti-reflet multicouches sur la couche métallique, ou par collage d'une vitre mince traitée anti-reflet.

Ces dispositifs sont destinés à former des claviers tactiles transparents pourvus de moyens intégrés de détection de l'effort appliqué. Un tel système est disposé devant un afficheur, par exemple à cristaux liquides, et permet de désigner tactilement, par exemple du doigt, une zone affichée particulière.

A cet effet on détermine par des mesures électriques la position du doigt sur la plaque métallisée et on détecte grâce aux jauges de contrainte un enfoncement de la plaque dû à une pression du doigt.

Ces dispositifs permettent donc de réaliser une surface tactile n'altérant pas notablement la vision des images présentées sur l'afficheur, et ceci pour un coût avantageux.

Les dispositifs de désignation tactile connus présentent toutefois un certain nombre d'inconvénients.

Tout d'abord, ils nécessitent une mécanique de support permettant le maintien et le guidage de la plaque de verre, ainsi que les réglages mécaniques de la position de la plaque sur chaque lame de façon à pouvoir compenser les tolérances de positionnement.

Par ailleurs, les connectiques de raccordement de la surface métallisée de la plaque ainsi que des jauges de contraintes doivent permettre de suivre les mouvements de la plaque.

La présente invention vise à palier ces inconvénients en fournissant un dispositif de désignation tactile dont l'agencement mécanique est particulièrement simple et qui peut ainsi être obtenu à un faible coût.

A cet effet, l'invention a pour objet un dispositif de désignation tactile à détection capacitive continue, comportant une plaque de verre recouverte d'un dépôt métallique sur sensiblement toute sa surface et supportée par des lames déformables, des moyens d'alimentation de la surface métallisée, et des jauges de contraintes montées sur lesdites lames pour mesurer leur déformation, caractérisé par le fait que les lames supportent ladite plaque à partir d'un circuit imprimé de montage et comportent chacune au moins une partie conductrice en contact à une de ses extrémités avec une piste d'alimentation formée sur le circuit imprimé et à son autre extrémité avec des organes de fixation de la plaque sur la lame, électriquement conducteurs et en contact avec la surface métallisée.

Dans un mode de réalisation particulier de l'invention lesdites lames possèdent à leur extrémité de fixation à la plaque une forme en fourche et lesdits organes de fixation comportant un écrou ayant une forme extérieure en diabolo dont la partie resserrée est engagée dans ladite fourche.

Un tel agencement permet un réglage aisé de la position de la plaque de verre par rapport au circuit imprimé de support, ainsi qu'un montage sans accès à l'arrière.

De préférence, les lames ont, dans leur partie fléchissante, une forme triangulaire. Une telle forme assure une déformation isoflexion, c'est-à-dire identique en tout point de la lame, ce qui permet de bénéficier d'un plus grande sensibilité des jauges collées sur les lames.

On prévoit de préférence quatre lames et quatre jauges identiques, ce qui permet de réduire les coûts, deux lames étant montées dans un sens tel que leurs jauges travaillent en compression (jauges vers l'utilisateur), et les deux autres lames étant montées inversées (jauges à l'opposé de l'utilisateur) de manière que leurs jauges travaillent en traction.

On peut ainsi monter les jauges en pont de Wheatstone et obtenir une sensibilité maximale.

Avantageusement, les jauges de contraintes sont également raccordées audit circuit imprimé.

Le dispositif selon l'invention est donc particulièrement compact puisque le circuit imprimé de support de la plaque de verre peut également porter aussi bien l'électronique de traitement des signaux liés au déplacement du doigt sur la plaque, que l'électronique de traitement des signaux issus des jauges de contraintes.

Par ailleurs, l'alimentation de la surface métallisée se fait directement par l'intermédiaire des lames de support et des organes de fixation de la plaque sur les lames à partir du circuit imprimé de support, supprimant ainsi les fils de connexion de l'art antérieur.

On décrira maintenant à titre d'exemple non limitatif un mode de réalisation particulier de l'invention en référence aux dessins schématiques annexés dans lesquels :

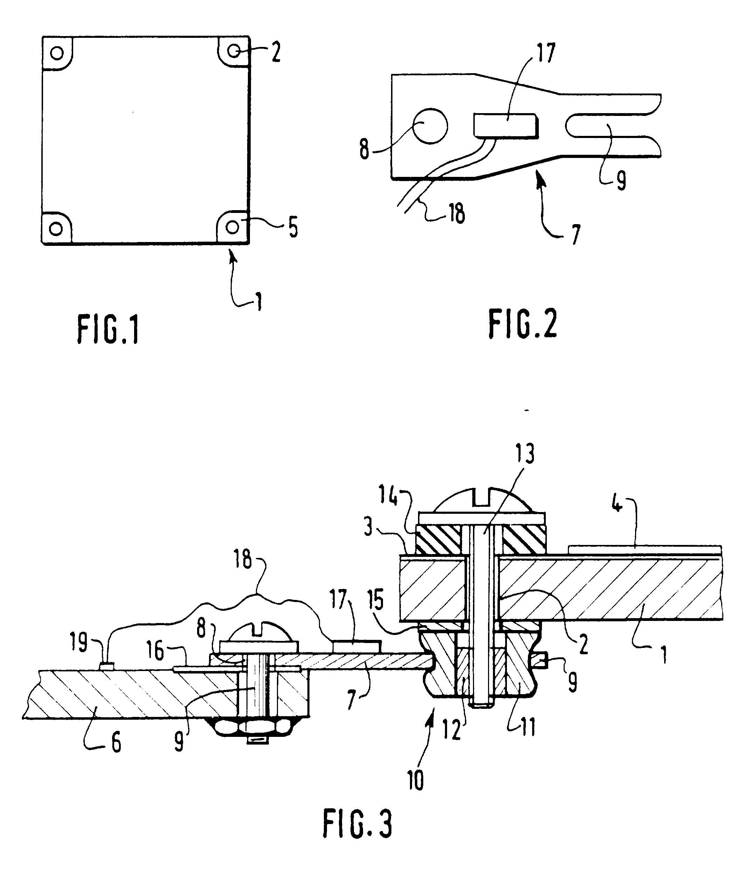

- la figure 1 est une vue de dessus d'une plaque métallisée utilisée dans le dispositif de l'invention,
- la figure 2 est une vue de dessus d'une lame déformable de support, et
- la figure 3 est une vue en coupe d'un des dispositifs de raccordement de la plaque de verre à son circuit imprimé de support.

La plaque de verre (1) utilisée ici est une plaque sensiblement carrée percée aux quatre coins de trous (2) permettant sa fixation. La plaque (1) est totalement recouverte d'un dépôt métallique 3 et d'une couche (4) d'isolation diélectrique traitée anti-reflet.

Des épargnes (5) de traitement sont ménagées aux quatre coins de la plaque (1) dans les zones des trous (2) afin d'assurer une prise de contact électrique avec la couche métallisée (3) dans ces zones.

La plaque de verre (1) est montée sur un circuit imprimé de support (6) par l'intermédiaire de lames métalliques déformables (7). Le circuit imprimé (6) porte également les circuits électroniques nécessaires à l'alimentation électrique et au traitement des signaux issus du dispositif. Ces circuits peuvent être de tout type connu et n'ont pas été représentés aux dessins.

Les lames 7 ont, dans leur partie fléchissante où est collée la jauge de contrainte, une forme triangulaire.

Chaque lame déformable (7) posséde à une de ses extrémités un trou (8) permettant le passage d'une vis (9) de fixation de la lame au circuit imprimé (6). A son autre extrémité la lame (7) posséde une forme en étrier délimitant une fente (9) permettant le montage des organes de fixation de la plaque (1) à la lame, sans nécessiter d'accéder à l'arrière du dispositif.

Ces organes comprennent un écrou (10) constitué d'une partie externe (11) en forme de diabolo et réalisée dans un matériau conducteur et un insert métallique (12) fileté intérieurement pour recevoir une vis de fixation (13). La tête de la vis (13) prend appui sur la surface métallisée (3) par l'intermédiaire d'une rondelle souple (14) réalisée en élastomère conducteur. Enfin, une ou plusieurs rondelles de réglage (15) permettent d'assurer un positionnement convenable en hauteur de la plaque de verre (1) par rapport au circuit imprimé (6). Le diabolo (11) engagé dans la fente (9) permet de positionner la plaque de verre (1) dans le plan parallèle au circuit imprimé (6).

La lame déformable (7) permet donc d'alimenter la couche conductrice (3) déposée sur la plaque (1) à partir d'une piste d'alimentation (16) formée à la surface du circuit imprimé (6) et dont l'extrémité est en contact avec l'extrémité correspondante de la lame (7).

Par ailleurs, une jauge de contrainte (17) est montée à la surface de la lame (7) pour en mesurer les déformations.

Les fils d'alimentation (18) de la jauge (17) sont raccordés à une autre piste (19) formée à la surface du circuit imprimé (6).

L'invention permet par conséquent d'alimenter très simplement la couche métallique (3) directement à partir du circuit imprimé (6) de support de la plaque (1) sans aucun fil de connexion. Les jauges (17) sont également alimentées à partir du circuit imprimé (6) par l'intermédiaire de fils de longueur minimale.

Les lames (7) assurent en outre simultanément un rôle de maintien et de guidage de la plaque dont la position par rapport au circuit imprimé (6) peut être aisément réglé.

Enfin, le dispositif selon l'invention est particulièrement compact, l'électronique associé à la plaque métallisée (1) et aux jauges de contraintes (17) pouvant être directement disposée sur le circuit imprimé (6).

## Revendications

1. Dispositif de désignation tactile à détection capacitive continue, comportant une plaque de verre (1) recouverte d'un dépôt métallique (3) sur sensiblement toute sa surface et supportée par des lames (7) déformables, des moyens d'alimentation de la surface métallisée, et des jauges de contraintes (17) montées sur lesdites lames pour mesurer leur déformation, caractérisé par le fait que les lames supportent ladite plaque à partir d'un circuit imprimé de montage (6) et comportent chacune au moins une partie conductrice en contact à une de ses extrémités avec une piste d'alimentation (16) formée sur le circuit imprimé et à son autre extrémité avec des organes de fixation (10-15) de la plaque sur la lame, électriquement conducteurs et en contact avec la surface métallisée.

2. Dispositif selon la revendication 1, dans lequel lesdites lames possèdent, à leur extrémité de fixation à la plaque, une forme en fourche, lesdits organes de fixation comportant un écrou (10) ayant une forme extérieure en diabolo dont la partie resserrée est engagée dans ladite fourche.

3. Dispositif selon l'une quelconque des revendications 1 et 2, dans lequel les lames ont, dans leur partie fléchissante, une forme triangulaire.

4. Dispositif selon l'une quelconque des revendications 1 à 3, comportant quatre lames déformables et quatre jauges de contraintes identiques, les lames étant montées de telle sorte que deux jauges travaillent en compression et deux jauges travaillent en traction.

5. Dispositif selon la revendication 4, dans lequel les jauges de contrainte sont montées, en pont de Wheatstone.

6. Dispositif selon l'une quelconque des revendications 1 à 5, dans lequel les jauges de contraintes sont raccordées audit circuit imprimé.

## Patentansprüche

1. Vorrichtung zur Eingabe mittels Berührung mit kontinuierlicher kapazitiver Erfassung, mit einer Glasplatte (1), die im wesentlichen auf ihrer gesamten Oberfläche mit einem metallischen Überzug (3) bedeckt und von verformbaren Zungen (7) gehalten ist, mit einer Versorgungseinrichtung für die metallisierte Oberfläche und Dehnungsmeßstreifen (17), die auf den genannten Zungen angebracht sind, um deren Verformung zu messen, dadurch gekennzeichnet, daß die Zungen die genannte Platte ausgehend von einer gedruckten Montageschaltung (6) halten, wobei jede wenigstens einen leitenden Teil aufweist, der sich an einem seiner Endabschnitte mit einer Versorgungsbahn (16), die auf dem gedruckten Schaltkreis ausgebildet ist, und an seinem anderen Endabschnitt mit den Befestigungselementen (10-15) der Platte an der Zunge, die elektrisch leitend sind und mit der metallisierten Fläche in Kontakt stehen, in Kontakt befindet.

2. Vorrichtung nach Anspruch 1, dadurch gekennzeichnet, daß die Zungen an ihrem Endabschnitt zur Befestigung an der Platte gabelförmig ausgebildet sind, wobei die Befestigungsorgane eine Mutter (10) aufweisen, die außen diaboloförmig ist und deren Taillenabschnitt in die Gabel eingesetzt ist.

3. Vorrichtung nach Anspruch 1 oder 2, dadurch gekennzeichnet, daß die Zungen in ihrem sich durchbiegenden Bereich dreieckförmig sind.

4. Vorrichtung nach einem der Ansprüche 1 bis 3, gekennzeichnet durch vier identische verformbare Zungen und Dehnungsmeßstreifen, wobe die Zungen so gehalten sind, daß zwei Meßstreifen in Druckrichtung und zwei Meßstreifen in Zugrichtung arbeiten.

5. Vorrichtung nach Anspruch 4, dadurch gekennzeichnet, daß die Dehnungsmeßstreifen als Wheatstone-Brücke geschaltet sind.

6. Vorrichtung nach einem der Ansprüche 1 bis 5, dadurch gekennzeichnet, daß die Dehnungsmeßstreifen mit dem gedruckten Schaltkreis verbunden sind.

## Claims

1. A touch input device with continuous capacitative detection, comprising a glass plate (1) covered with a metallic coating (3) over substantially its entire surface and supported by deformable tongues (7), power supply means for the metal-coated surface, and strain gauges (17) mounted on the said tongues to measure their deformation, characterized by the fact that the tongues support the said plate from a printed mounting circuit (6) and each one comprises at least one conductor part, with one end in contact with a power supply track (16) formed on the printed circuit and the other end in contact with securing elements (10-15) holding the plate on the tongue, which are electrical conductors and are in contact with the metal-coated surface.

2. A device as claimed in Claim 1, wherein those ends of said tongues which are attached to the plate are fork-shaped, the said securing elements comprising a nut (10) which is externally diabolo-shaped, the pinched part being engaged in the said fork.

3. A device as claimed in either of Claims 1 or 2, wherein the bending part of the tongues is triangular in shape.

4. A device as claimed in any of Claims 1 to 3, comprising four deformable tongues and four strain gauges which are identical, the tongues being mounted such that two gauges act for compression and two gauges act for traction.

5. A device as claimed in Claim 4, wherein the strain gauges are mounted in a Wheatstone bridge arrangement.

6. A device as claimed in any of Claims 1 to 5, wherein the strain gauges are connected to the said printed circuit.
